# FASCICULE DE BREVET EUROPEEN

(11) **EP 0 437 839 B1**
(45) Date de publication et mention de la délivrance du brevet: **12.10.1994**
(21) Numéro de dépôt: 90125592.7
(22) Date de dépôt: 27.12.1990
(51) Int. Cl.: H02G 15/14, H05K 5/06

(54) **Boîtier pour circuits électroniques immergés**
Gehäuse für tauchfähige elektronische Schaltungen
Case for submersible electronic circuits

(30) Priorité: 29.12.1989 FR 8917464
(43) Date de publication de la demande: 24.07.1991
(73) Titulaire: ALCATEL CIT, 75008 Paris (FR)
(72) Inventeur: Bitller, Jean-Pierre, F-91400 Orsay (FR); Pelet, André, F-78310 Maurepas (FR); Wirth, Guy, F-75014 Paris (FR); Hang-Hu, Monique, F-91250 Saintry-sur-Seine (FR)
(74) Mandataire: Weinmiller, Jürgen

(56) Documents cités:
- EP-A- 0 338 477
- FR-A- 2 596 231
- GB-A- 2 153 151
- GB-A- 2 193 552

## Description

L'invention concerne un boîtier pour circuits électroniques immergés, tels que ceux constituant un répéteur pour câble de liaison sous-marine.

Ce type de boîtier doit avoir une résistance mécanique élevée pour supporter les opérations de pose et de récupération, qui le soumettent à des chocs, et pour supporter la pression élevée régnant au fond de la mer. En outre, il doit avoir un bon isolement électrique, par rapport aux circuits électroniques qu'il contient, ces derniers pouvant être à un potentiel électrique très différent de celui du boîtier, en raison de leur mode de téléalimentation par les extrémités de la liaison. Enfin, ce type de boîtier doit assurer une bonne évacuation de la chaleur engendrée par les circuits électroniques, pour éviter que leur température de fonctionnement s'élève considérablement et nuise à leur fiabilité à long terme. Les liaisons sous-marines actuelles qui fonctionnent à des débits élevés, sont équipées de boîtiers contenant des circuits électroniques de plus en plus denses, ce qui entraîne une augmentation de la quantité de chaleur à dissiper. Il est donc nécessaire d'augmenter la capacité de dissipation des boîtiers de répéteur, et de veiller à une bonne uniformité de cette dissipation, pour tous les circuits électroniques contenus dans un répéteur.

La demande de brevet français n°2 630 575 décrit un boîtier comportant :
- une enveloppe rigide, de forme cylindrique à section circulaire, thermiquement conductrice, et fermée de manière étanche à ses extrémités;
- des réceptacles rigides et thermiquement conducteurs, ayant une face dont la forme est complémentaire de la forme de la paroi interne de l'enveloppe; par exemple, en forme de secteur de cylindre couvrant 60°, s'il y a six réceptacles;
- des matelas de fils de cuivre, placés respectivement entre les faces des réceptacles et la paroi, pour assurer la transmission de la chaleur des réceptacles vers l'enveloppe;
- un dispositif mécanique pour plaquer chaque réceptacle et son matelas contre la paroi, pour assurer un bon contact thermique entre le matelas et le réceptacle, et entre le matelas et la paroi.

Ce dispositif mécanique comporte deux ressorts de type annulaire fendu, placés respectivement aux deux extrémités du boîtier, et qui sont entourés chacun par les six réceptacles. Les réceptacles prennent appui sur les ressorts annulaires par l'intermédiaire de supports, en forme de dièdre. Chaque support appuie sur la paroi externe d'un ressort annulaire, par les parois internes de son dièdre. Les parois externes du dièdre constituent deux surfaces d'appui respectivement pour deux réceptacles. Pour un boîtier comportant six réceptacles, il y a trois supports à chaque extrémité du boîtier.

Sur chaque support sont articulés deux réceptacles, chaque réceptacle comportant deux ergots placés respectivement aux deux extrémités du réceptacle, à proximité de l'un des grands côtés. Les ergots de deux réceptacles articulés sur un même support tourillonnent dans deux trous très voisins, percés dans le support. Les deux réceptacles sont libres en rotation autour de ces ergots, lorsque l'ensemble des réceptacles est extrait du boîtier pour des opérations de maintenance. Lorsque les réceptacles sont placés à l'intérieur du boîtier, ils ne tourillonnent plus, ils sont constamment en appui sur les parois externes du dièdre, et tout se passe comme si les deux réceptacles et leurs deux supports ne formaient qu'une seule pièce rigide subissant des forces centrifuges engendrées par les deux ressorts annulaires.

Chaque support a une certaine liberté de translation dans une direction radiale, pour permettre aux ressorts de pousser l'ensemble des deux réceptacles, et leurs matelas, contre la paroi. En outre, chaque support est libre en rotation autour d'un axe parallèle à l'axe de symétrie du boîtier. Grâce à ces deux degrés de liberté, les forces exercées par les deux ressorts se répartissent sur les extrémités des six réceptacles. La répartition de ces forces dépend des irrégularités de l'espace subsistant entre les réceptacles et la paroi; et des irrégularités de répartition de la matière dans le matelas de fils de cuivre. L'espace subsistant entre un réceptacle et la paroi est affecté notamment par les déformations de l'enveloppe causées par les hautes pressions des grandes profondeurs sous-marines. Il peut être affecté aussi par un déplacement des réceptacles, consécutif à un choc violent pendant la pose. Les forces exercées par un ressort unique sur les extrémités de six réceptacles sont interdépendantes. Elles sont mal déterminées et donc mal réparties, à cause de cette interdépendance et de l'absence de moyens de réglage. Il en résulte une non uniformité de la pression sur les différents matelas et, par conséquent, une non uniformité de la conduction thermique entre les réceptacles et la paroi. Certains réceptacles auront donc une température plus élevée que d'autres, pour une même production de chaleur par leurs circuits électroniques.

Le but de l'invention est de remédier à cette non uniformité de répartition des forces, pour obtenir une conduction thermique aussi uniforme que possible pour tous les réceptacles. L'objet de l'invention est un boîtier dans lequel les moyens mécaniques pour plaquer chaque réceptacle contre la paroi exercent des forces individualisées et réglables indépendamment.

Selon l'invention, un boîtier pour circuits électroniques immergés, comportant :
- une enveloppe rigide de forme cylindrique à section circulaire, thermiquement conductrice, fermée de manière étanche à ses extrémités;
- une pluralité de réceptacles rigides et thermiquement conducteurs, ayant chacun une face dont la forme est complémentaire de la forme de la paroi interne de l'enveloppe, et contenant des circuits électroniques;
- des couches de matériaux souples, thermiquement conducteurs, placées respectivement entre les dites faces et la dite paroi;
- des moyens pour plaquer chaque réceptacle, et les couches de matériaux souples, contre ladite paroi;
   est caractérisé en ce que les moyens pour plaquer comportent, à chaque extrémité du boîtier:
- une pluralité de dispositifs de fixation solidaires de l'enveloppe, répartis régulièrement autour de l'axe de symétrie de l'enveloppe, chacun exerçant une force radiale centrifuge et étant réglable individuellement;
- des moyens pour transmettre à au moins un réceptacle la force radiale centrifuge exercée par chaque dispositif de fixation.

Selon une autre caractéristique, les moyens pour transmettre la force exercée par chaque dispositif de fixation comportent un dispositif élastique, tel que des rondelles élastiques ou un ressort, afin que chaque dispositif de fixation continue à exercer une pression à peu près constante, même si une déformation de la paroi interne de l'enveloppe, ou un choc, modifie l'espace subsistant entre les faces des réceptacles et la paroi.

D'autre part, ce dispositif élastique rend plus progressif le réglage de la force exercée par chaque dispositif de fixation.

Selon une autre caractéristique : les moyens pour plaquer comportent en outre une première couronne, à chaque extrémité du boîtier; les moyens pour transmettre comportent, à chaque extrémité de boîtier, une pluralité de supports, chacun étant solidaire de l'extrémité d'au moins un réceptacle; chaque dispositif de fixation comporte une vis vissée dans la première couronne selon une direction radiale; et le dispositif élastique de chaque dispositif de fixation est intercalé entre la vis de ce dispositif de fixation et l'un des supports. La première couronnne permet de percer des trous pour visser les vis, ce qui serait plus difficile à réaliser et à contrôler dans le cas d'un usinage direct dans l'épaisseur de la paroi, sous peine en supplément d'affaiblir sa résistance mécanique. Les supports permettent de transmettre, en la répartissant, la force exercée par les vis, et permettent de regrouper plusieurs réceptacles, éventuellement.

Selon une autre caractéristique, chaque première couronne est amovible et est fixée à une seconde couronne qui est fixe et est intégrée à la paroi; en outre, la première et la seconde couronne ont des surfaces de contact qui sont uniquement radiales, les autres surfaces de ces deux couronnes n'étant pas en contact mais étant séparées par des jeux prédéterminés, dans le but d'assurer une relative indépendance des deux couronnes et un certain amortissement, dans le cas où un choc sur l'extérieur de l'enveloppe est transmis par la seconde couronne, pour éviter qu'un tel choc se propage jusqu'aux réceptacles et provoque des dégâts dans les circuits électroniques.

Selon une autre caractéristique, un secteur de la seconde couronne située à l'une des extrémités du boîtier est absent, par exemple sur un angle de 120°, pour faciliter la mise en place des réceptacles à l'intérieur de l'enveloppe; la première couronne comportant alors un secteur en surépaisseur remplissant l'espace laissé libre dans ladite seconde couronne, pour que l'ensemble de la première et de la seconde couronne constitue une couronne d'épaisseur constante et donc de résistance mécanique constante. Un mode de réalisation particulier du boîtier selon l'invention, permet d'assurer, si on le désire, un isolement électrique d'un ou plusieurs réceptacles par rapport à la paroi interne de l'enveloppe.

L'invention sera mieux comprise et d'autres détails apparaîtront à l'aide de la description, ci-dessous, d'un exemple de réalisation, et des figures l'accompagnant :
- la figure 1 représente une vue d'ensemble de cet exemple de réalisation;
- la figure 2 représente et illustre la manière dont sont appliquées les forces centrifuges sur les réceptacles;
- la figure 3 représente une vue en coupe d'un réceptacle et des circuits électroniques qu'il contient;
- la figure 4 représente une vue de face d'une partie de cet exemple de réalisation, montrant notamment un support et une pièce isolante correspondant à deux réceptacles;
- la figure 5 représente une vue en coupe partielle montrant un détail de la réalisation et de la fixation de ce support et de cette pièce isolante;
- la figure 6 représente une vue en coupe partielle d'une partie de cet exemple de réalisation;
- la figure 7 représente une vue en coupe partielle d'une autre partie de cet exemple de réalisation, en montrant les jeux ménagés entre la première et la seconde couronne;
- les figure 8 et 9 montrent respectivement deux vues éclatées de la première et de la seconde extrémité de cet exemple de réalisation.

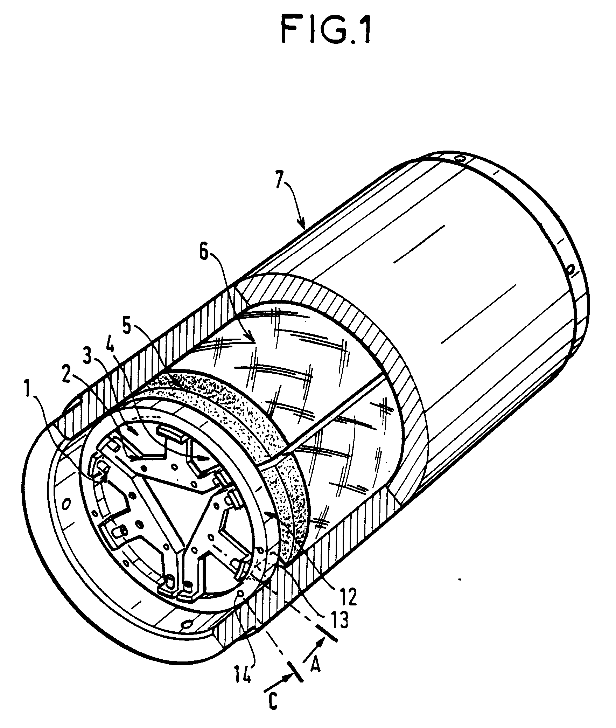

La figure 1 ne représente pas les couvercles qui, normalement, ferment de manière étanche les deux extrémités du boîtier. Ce boîtier comporte une enveloppe 7, en acier, qui est représentée partiellement enlevée pour laisser apparaître les autres composants du boîtier.

Dans cet exemple de réalisation, le boîtier contient six réceptacles, tels que les réceptacles 3 et 4, ayant une face longitudinale externe en forme de secteur cylindrique couvrant 60° degrés et parallèle à la paroi interne de l'enveloppe 7. Les réceptacles sont fixés, par paire, sur trois supports, à chaque extrémité du boîtier. Par exemple, les réceptacles 3 et 4 sont fixés à un support 2 qui est lui-même fixé à une couronne amovible 12, au moyen de trois dispositifs de fixation, 1, qui seront décrits plus loin, et qui exercent des forces radiales centrifuges sur le support 2. La couronne amovible 12 est fixée par quatre vis 14 à une couronne fixe 13 qui est intégrée à la paroi interne de l'enveloppe 7. Les couronnes 12 et 13 sont en acier. Les détails de réalisation des deux couronnes 12 et 13 seront décrits plus loin.

A l'autre extrémité, non visible du boîtier, les réceptacles 3 et 4 sont solidaires d'un support identique au support 2. Deux couronnes, semblables aux couronnes 12 et 13, supportent les réceptacles 3 et 4 par l'intermédiaire dudit support. Ces couronnes seront décrites plus loin.

Les faces longitudinales externes de deux réceptacles (3, 4) montés sur un même support sont recouvertes par un matelas 6. Chacun de ces matelas est constitué essentiellement d'un tricot de fils de cuivre, qui a pour fonction de conduire la chaleur des réceptacles vers l'enveloppe 7. Comme il apparaîtra dans ce qui suit, le matelas 6 est entouré d'une toile métallique souple qui évite tous risques de dispersion, à l'intérieur du boîtier, de bouts de fils de cuivre échappés du tricot. Pour isoler électriquement si nécessaire, les réceptacles par rapport à l'enveloppe 7, une feuille de matière isolante, non représentée ici, est intercalée entre le matelas 6 et la surface correspondante de la paroi interne de l'enveloppe. Dans le même but, le support 2 de chaque paire de réceptacles est muni d'une pièce isolante 5, appelée casquette isolante, qui assure l'isolation de l'extrémité de cette paire de réceptacles et de l'extrémité du matelas 6 correspondant, par rapport à l'enveloppe 7. La couronne fixe 13 est située entre la couronne amovible 12 et les casquettes isolantes telles que la casquette 5, la couronne amovible 12 étant la pièce la plus proche de l'extrémité du boîtier.

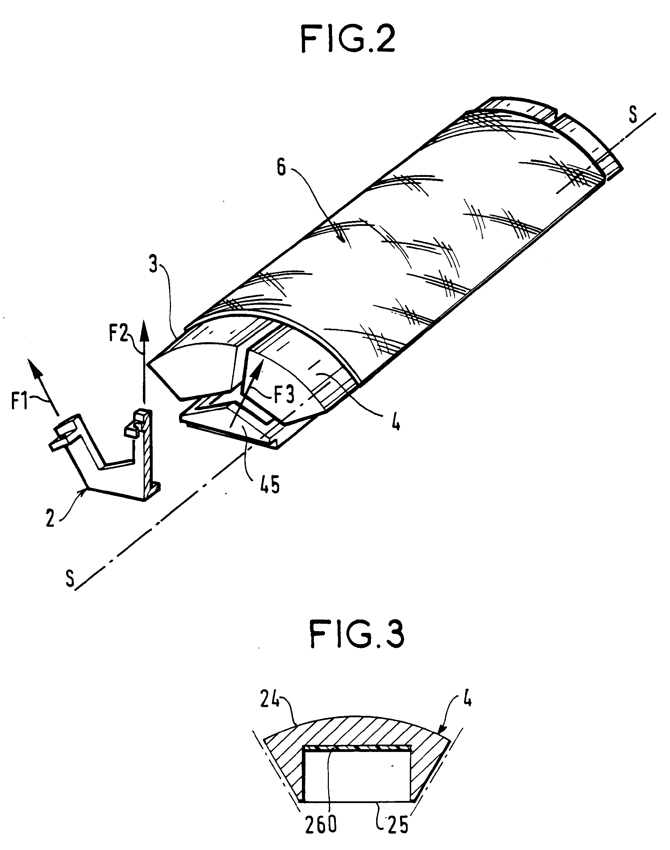

La figure 2 représente une paire de réceptacles 3 et 4 avec leur matelas 6, un support 2 à moitié coupé selon son plan de symétrie, et une entretoise 45; pour montrer comment sont transmises trois forces F1, F2, F3 exercées par trois dispositifs de fixation, non représentés, tels que le dispositif 1.

Ces forces sont radiales et centrifuges, par rapport à l'axe SS de symétrie du boîtier, et sont réglables individuellement. Elles sont appliquées à trois branches du support 2, qui est solidaire d'une extrémité de l'entretoise 45. Les deux réceptacles 3, 4 reposent sur cette entretoise 45. Le support 2 et l'entretoise 45 transmettent les forces F1, F2, F3 en les répartissant sur toute la longueur des réceptacles. Les forces F1, F2, F3 sont réglées de façon à obtenir une pression uniforme sur le matelas 6.

Les détails de réalisation et d'assemblage du support 2 et de l'entretoise 45 seront décrits plus loin.

La figure 3 représente une vue en coupe transversale du réceptacle 4, donnée à titre d'exemple. Sa section a une forme de secteur circulaire ayant un angle voisin de 60°, avec une troncature 25 située vers l'axe de symétrie SS du boîtier. Une cavité parallèllépipédique est creusée dans cette troncature 25. Un circuit électronique 260 est fixé au fond de cette cavité de telle sorte que la chaleur qu'il produit diffuse à travers le fond du réceptacle 4 en direction de sa surface externe 24.

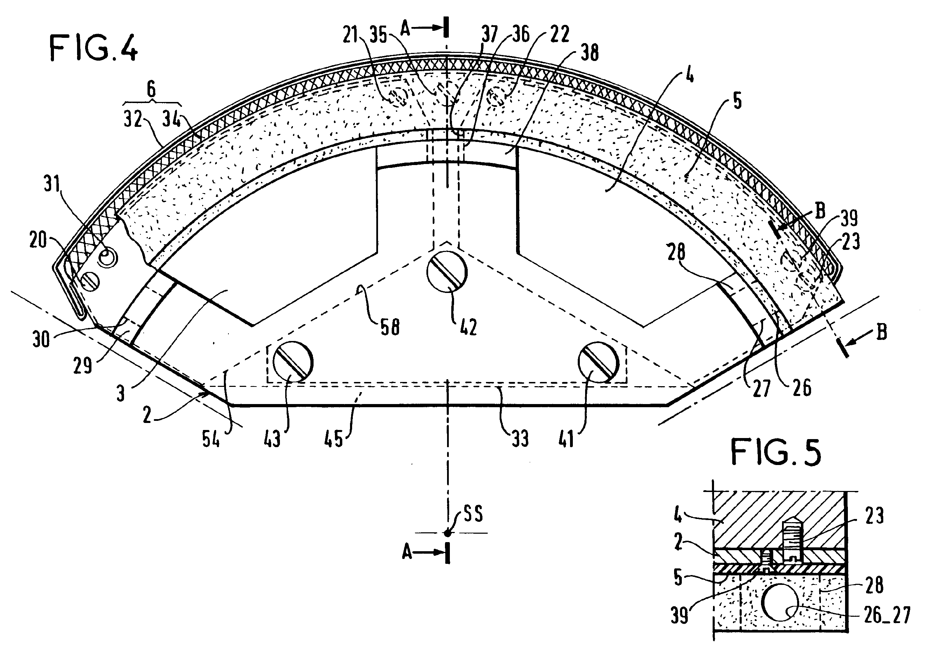

La figure 4 montre, en vue de face, les réceptacles 3 et 4 solidaires du support 2, ce dernier étant équipé de la casquette isolante 5, du matelas 6, et de l'entretoise 45. Le matelas 6 comporte : une couche de tricot de fils de cuivre, 34, enveloppée dans une toile métallique souple, 32, qui viendra en contact d'une part, avec chacune des faces longitudinales externes des réceptacles, d'autre part, avec la paroi interne de l'enveloppe du boîtier ou avec la feuille isolante préalablement collée sur ladite paroi interne de l'enveloppe au droit des réceptacles si une isolation entre les réceptacles 3, 4 et le boîtier doit être réalisée; il est bien entendu que dans ce cas la feuille isolante est suffisamment fine pour transmettre la chaleur mais néanmoins suffisante pour assurer l'isolement électrique. La casquette 5 est fixée au support 2 par trois vis en polyamide : 35, 39, et une, non représentée, vissée dans le trou fileté 31. Le support 2 est fixé à une entretoise 45, par trois vis 41 à 43. Le réceptacle 3 et le réceptacle 4 sont solidaires du support 2 par des ergots 20 à 23. Ils s'appuient sur l'entretoise 45 par des surfaces d'appuis 54 et 58. L'entretoise 45 s'appuie sur le support 2 par un épaulement 33.

La figure 5 montre une coupe partielle du support 2, associé au réceptacle 4 et à la casquette 5, selon la direction de vue BB. Cette figure montre que l'ergot 23 est constitué par une vis dont la tête a le même diamètre que la tige filetée. Cette tête est encastrée dans un trou lisse percé dans le support 2. La casquette 5 est vissée par la vis à tête fraisée 39, contre le support 2, du côté opposé au réceptacle 4, de telle façon que la tête de vis soit noyée à l'intérieur de l'épaisseur de la casquette 5. La casquette 5 est mise en place après avoir vissé la vis 23 et des vis homologues constituant les ergots 20, 21, 22. Ces vis ne dépassent pas de leur trou dans le support 2 et elles sont masquées par la casquette 5 après que celle-ci ait été mise en place.

La forme générale du support 2 est une forme plane, en forme de secteur de disque, faisant un angle de 120°. Elle comporte trois pattes : 29, 38, 28, orthogonales au plan du support 2 et percées respectivement de trois trous lisses : 30, 36, 27 en coïncidence avec des trous lisses 37, 26, percés dans la casquette 5. Un morceau de la casquette 5 n'étant pas représenté sur la figure 4, le trou correspondant au trou 30 du support 2 n'apparaît pas. Ces trous sont destinées à fixer le support 2 à la couronne amovible 12 en y insérant des dispositifs de fixation 1 non représentés.

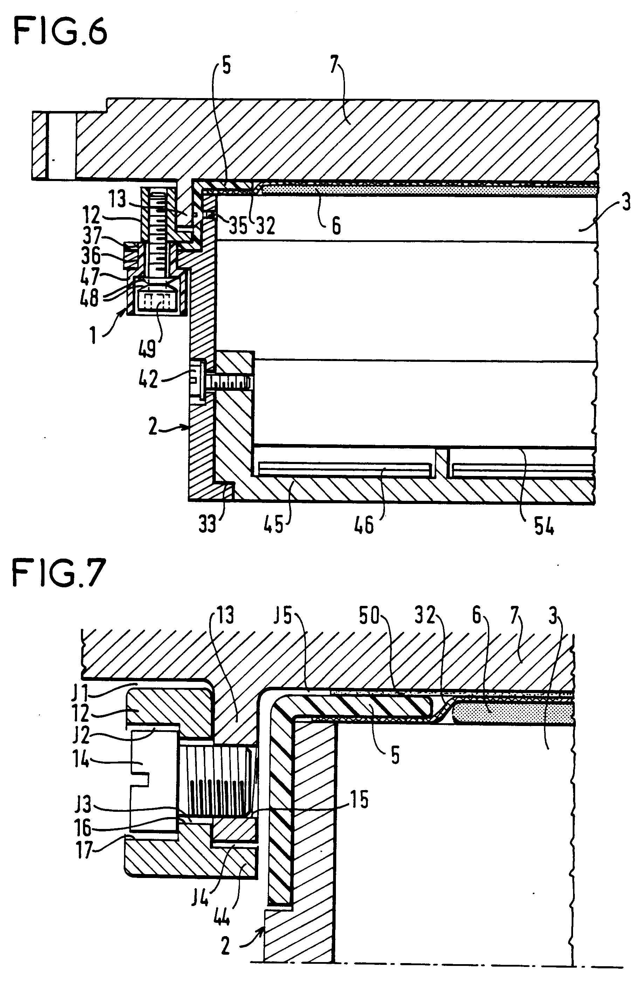

La figure 6 représente une vue en coupe partielle de cet exemple de réalisation, selon la direction de vue AA montrée sur les figures 1 et 4. Le plan de coupe passe par l'axe de symétrie SS du boîtier et par les axes des vis 35 et 42, c'est-à-dire passe entre les réceptacles entre 3 et 4, sans les couper. La figure 6 montre la disposition de l'un des dispositifs de fixation 1, par rapport à : la casquette isolante 5; la couronne amovible 12; le support 2; et la couronne fixe 13. Elle montre l'entretoise 45 qui court parallèlement aux réceptacles 3 et 4, et qui constitue elle-même un réceptacle pour des circuits électroniques 46 dissipant peu de puissance et pouvant donc être placés au voisinage de l'axe de symétrie du boîtier. Cette entretoise 45 vient en appui sur l'épaulement 33 et est fixée au support 2 notamment par la vis 42.

Le réceptacle 3 qui est solidaire du support 2 par les ergots constitués des vis 20 et 21 qui ne sont pas visibles sur cette figure 6 vient en appui sur chacun des bords 58 des deux extrémités de l'entretoise 45 et sur son bord longitudinal extérieur 54; ces bords sont usinés selon un angle leur permettant de présenter un plan de joint parfaitement complémentaire de celui du réceptacle 3. Le support 2 transmet donc vers le réceptacle 3, par l'intermédiaire de l'entretoise 45, une force pour le plaquer contre le matelas 6, s'appuyant sur l'enveloppe 7. La casquette 5 isole le support 2 et notamment la patte 38, et isole l'extrémité du réceptacle 3, par rapport aux couronnes 12 et 13, et à l'enveloppe 7. La casquette 5 est fixée au support 2 par la vis 35 notamment. La toile métallique 32 qui recouvre le matelas 6 est coincée entre la casquette 5 et la face externe du réceptacle 3.

Le dispositif de fixation 1 est un sous-ensemble élastique et électriquement isolant comportant : une vis 49, ayant une tête à 6 pans creux; un couple de rondelles élastiques 48, de type belleville; un canon isolant 47, entourant à la fois la tête de la vis 49, le couple de rondelles 48 situé sous la tête, et le passage de la vis 49 dans les trous 36 et 37 respectivement à travers le support 2 et à travers la casquette 5. La vis 49 est vissée dans la couronne amovible 12, selon une direction radiale et centrifuge. La couronne 12 étant fixée, par ailleurs, sur la couronne fixe 13, le serrage de la vis 49 comprime le couple de rondelles 48 et ce dernier transmet une force au support 2, par l'intermédiaire du canon 47. Cette force appuie la casquette 5 contre la couronne amovible 12.

La présence du couple de rondelles élastiques 48, permet d'exercer une force réglable très progressivement en serrant plus ou moins la vis 49. La force exercée peut être réglée avec précision en utilisant une clé dynamométrique pour visser la vis 49. Ces rondelles élastiques 48 permettent aussi de maintenir une force à peu près constante en dépit des variations éventuelles de l'espace entre l'enveloppe 7 et le réceptacle 3, par exemple si la pression déforme la paroi de l'enveloppe 7 ou si un choc violent arrive à déplacer le réceptacle 3 par rapport à l'enveloppe 7. D'autre part, ces rondelles élastiques contribuent à amortir la transmission d'un choc vers les circuits électroniques lorsque le choc a pour effet de déplacer les réceptacles 3 et 4 radialement en direction du centre du boîtier, car alors ces rondelles peuvent s'écraser momentanément puis reprendre leur forme initiale.

La figure 7, qui est à une échelle plus grande que la figure 6, montre une vue en coupe partielle de cet exemple de réalisation selon une direction de vue C représentée sur la figure 1. Le plan de coupe passe par l'axe de symétrie du boîtier et par une vis 14 de fixation de la couronne amovible 12 sur la couronne fixe 13. Elle montre les jeux J1 à J4 qui sont ménagés entre ces deux couronnes afin d'amoindrir la transmission des chocs de la couronne fixe 13 à la couronne amovible 12, puis aux circuits électroniques, via le support 2, dans le cas de contraintes dépassant les caractéristiques mécaniques des dispositifs de fixation 1. La figure 7 montre que les couronnes 12 et 13 sont en contact uniquement par une surface plane qui est radiale, les autres surfaces étant séparées par des jeux prédéterminés.

La vis 14 fixe la couronne amovible 12 sur la couronne fixe 13. L'axe de la vis 14 est parallèle à l'axe de symétrie du boîtier. Elle traverse la couronne 12 par un trou lisse 16, avec un jeu J3. Elle est vissée dans un trou taraudé 15, dans la couronne 13, et sa tige filetée ne dépasse pas à la sortie de ce trou 15. La tête de la vis 14 est contenue dans un lamage 17 avec un jeu J2. La couronne amovible 12 comporte un épaulement 44 qui prolonge la couronne 12 en recouvrant la partie de la couronne 13 située la plus près de l'axe de symétrie du boîtier, mais avec un jeu J4. La périphérie de la couronne 12 est parallèle à la paroi de l'enveloppe 7 avec un jeu J1.

Les jeux J1 à J4 permettent d'éviter une transmission directe d'un choc de l'enveloppe 7 à la couronne 12, la transmission ne pouvant se faire que par le frottement des surfaces radiales en contact, et par le frottement de la tête de la vis 14 sur le fond du lamage 17, qui a lui aussi une surface radiale plane.

Les jeux J1, J2, J3, ont pour valeur 0,5 mm dans cet exemple de réalisation; et le jeu J4 a pour valeur 0,25 mm. Le jeu J4 est le plus petit, pour qu'en cas de choc violent déplaçant la couronne 12 par rapport à la couronne 13, l'épaulement 44 vienne buter contre la couronne 13, évitant ainsi que la tige filetée de la vis 14 soit cisaillée par la couronne 12.

La figure 7, montre aussi qu'un jeu J5 sépare la casquette 5, d'une part, et la paroi interne de l'enveloppe 7 et la couronne fixe 13, d'autre part. Ce jeu J5 est supérieur à J1 pour éviter la transmission d'un choc par l'intermédiaire de la casquette isolante 5.

La figure 7 montre une feuille 50, électriquement isolante et thermiquement conductrice, qui est collée sur la paroi de l'enveloppe 7 pour l'isoler électriquement du tissu métallique 32.

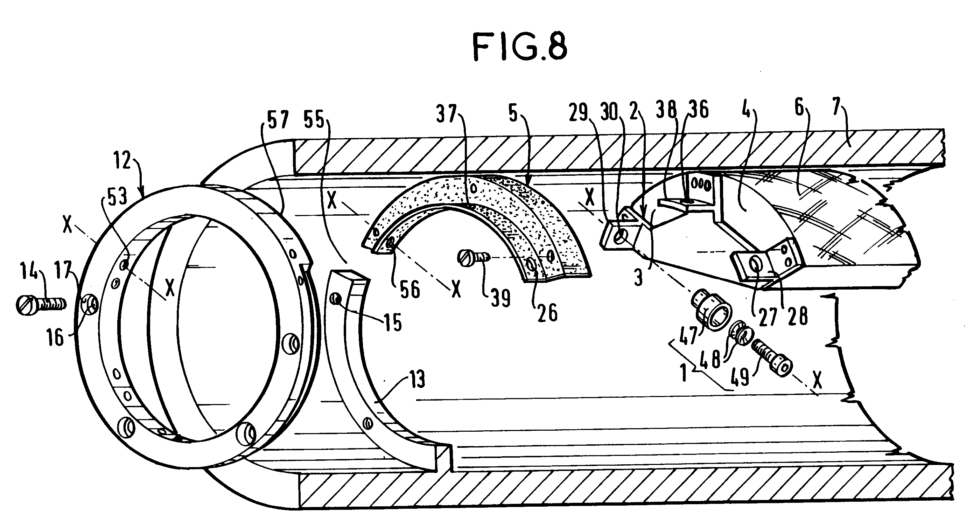

La figure 8 représente une vue éclatée et en coupe d'une première extrémité de cet exemple de réalisation, pour montrer le montage de la couronne amovible 12, de la casquette isolante 5, et du support 2 portant les réceptacles 3 et 4, et de leur matelas 6. Les pièces sont montées dans l'ordre où elles sont décrites ci-dessous.

Les réceptacles 3 et 4 sont préalablement solidarisés au support 2, déjà équipé de l'entretoise 45, puis sont munis du matelas 6 et de la casquette 5, la casquette étant fixée par trois vis, telle que la vis 39.

Au total, trois sous-ensembles ainsi constitués sont introduits successivement dans l'enveloppe 7. Pour faciliter la mise en place de ces trois sous-ensembles, la couronne fixe 13, qui est intégrée à l'enveloppe 7 et qui n'est donc pas démontable, ne couvre qu'un secteur de 240°. Un secteur libre 55 permet l'introduction d'un sous-ensemble ayant une forme de secteur cylindrique occupant un angle de 120°.

Puis, la couronne amovible 12 est mise en place, contre la couronne fixe 13, et est fixée au moyen de quatre vis 14, passant à travers des trous lisses 16 aménagés dans la couronne 12. Ces vis 14 sont vissées dans des trous taraudés 15, de la couronne 13. L'axe de ces vis est parallèle à l'axe de l'enveloppe 7. La couronne 12 comporte un secteur 57 en surépaisseur, remplissant l'espace du secteur 55 laissé libre dans la couronne 13. Ainsi, la surépaisseur du secteur 57 remédie à la discontinuité de la couronne 13 et assure au boîtier une résistance mécanique uniforme autour de son axe de symétrie. Enfin, les supports 2, sont fixés à la couronne 12 et les matelas 6 sont mis sous pression au moyen des dispositifs de fixation 1.

Le support 2 est fixé en mettant en place tout d'abord un dispositif de fixation 1 dans le trou de la patte 38 situé dans le plan de symétrie du support 2. Ce premier dispositif de fixation, non représenté, permet de rapprocher les pattes extrêmes du support 2 de la paroi intérieure de la couronne amovible 12, jusqu'à ce que les trous des pattes 28 et 29 soient sensiblement en coïncidence avec les trous filetés tels que le trou 53, qui sont percés dans la couronne amovible 12, et qui sont destinés à recevoir des dispositifs de fixation 1. En effet, tant que cette coïncidence n'est pas réalisée, il n'est pas possible de visser les deux autres dispositifs de fixation.

La figure 8 montre aussi, à titre d'exemple, l'axe XX selon lequel est mis en place un dispositif de fixation 1 traversant le trou 30 de la patte 29, puis traversant un trou 56 correspondant dans la casquette 5, pour être vissé dans un trou fileté 53 de la couronne amovible 12. Ce dispositif de fixation est analogue à celui qui a été utilisé pour fixer la patte 38 à la couronne 12 et à celui qui est utilisé pour fixer la patte 28.

L'utilisation d'une clé dynamomètrique ou de vis épaulées permet de régler avec précision la force exercée par chaque dispositif de fixation 1, de telle sorte que les forces soient identiques sur les pattes 28 et 29, aux deux extrémités de chaque paire de réceptacles, afin d'obtenir une pression uniforme sur les matelas 6.

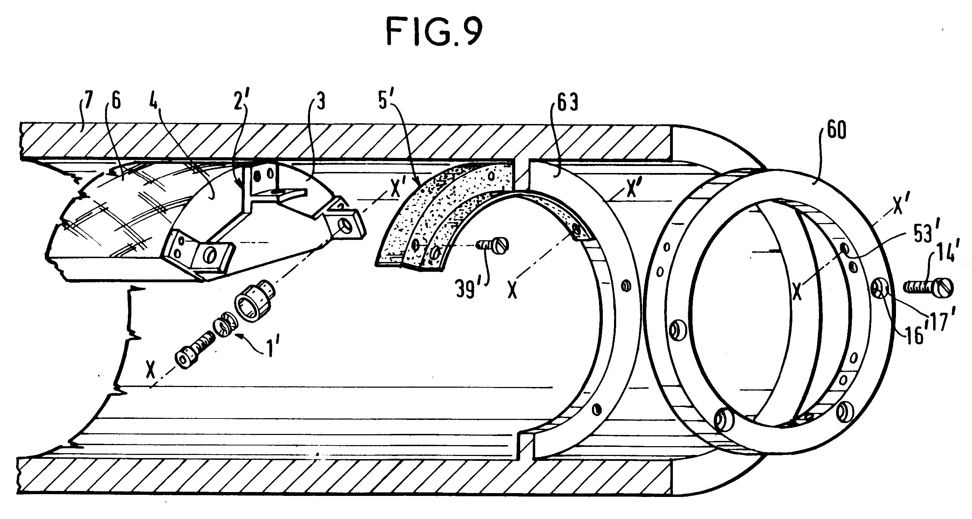

La figure 9 représente une vue en coupe, éclatée, de l'autre extrémité du boîtier. La plupart des éléments sont identiques à ceux décrits ci-dessus et ils portent alors la même référence numérique, avec l'indice "'". La seule différence découle du fait que cette extrémité n'est pas utilisée pour l'insertion des sous-ensembles dans l'enveloppe. Par conséquent, il n'est pas nécessaire de supprimer un secteur de la couronne fixe. Cette extrémité comporte une couronne fixe 63 qui fait le tour complet de la paroi intérieure de l'enveloppe 7; et une couronne amovible 60 qui ne comporte pas de secteur en surépaisseur.

La portée de l'invention n'est pas limitée à l'exemple décrit ci-dessus. Il est à la portée de l'homme de l'art d'adapter ce boîtier pour un nombre différent de supports ou de réceptacles en forme de secteur circulaire. Les dispositifs de fixation, pour plaquer les réceptacles contre la paroi, peuvent comporter des moyens élastiques différents, par exemple un ressort hélicoïdal.

Le nombre des dispositifs de fixation peut être différent de trois par support. Il en faut au moins un par support, mais leur nombre n'est pas limité.

## Revendications

1. Boîtier pour circuits électroniques immergés, comportant :
- une enveloppe rigide (7), de forme cylindrique à section circulaire, thermiquement conductrice, fermée de manière étanche à ses extrémités;
- une pluralité de réceptacles (3, 4) rigides et thermiquement conducteurs, ayant chacun une face dont la forme est complémentaire de la forme de la paroi interne de l'enveloppe, et contenant des circuits électroniques;
- des couches (6, 32, 34) de matériaux souples, thermiquement conducteurs, placées respectivement entre les dites faces et la dite paroi;
- des moyens pour plaquer chaque réceptacle, et les couches de matériaux souples, contre ladite paroi;
caractérisé en ce que les moyens pour plaquer comportent, à chaque extrémité du boîtier:
- une pluralité de dispositifs de fixation (1, 1′), solidaires de l'enveloppe (7), et répartis régulièrement autour de l'axe de symétrie de l'enveloppe, chacun exerçant une force radiale centrifuge et étant réglable individuellement;
- des moyens (2, 45) pour transmettre à au moins un réceptacle (3, 4) la force radiale centrifuge exercée par chaque dispositif de fixation (1, 1′).

2. Boîtier selon la revendication 1, caractérisé en ce que les dispositifs de fixation (1, 1′) comportent un dispositif élastique (48, 48′).

3. Boîtier selon la revendication 1 et 2, caractérisé en ce que :
- les moyens pour plaquer comportent en outre une première couronne (12, 60), à chaque extrémité du boîtier;
- les moyens pour transmettre comportent , à chaque extrémité du boîtier, une pluralité de supports (2, 2′), et comportent une pluralité d'entretoises (45); chaque entretoise étant fixée à deux supports (2, 2′) situés respectivement aux deux extrémités du boîtier, et supportant au moins un réceptacle (3, 4);
- chaque dispositif de fixation (1, 1′) comporte une vis (49, 49′) vissée dans la première couronne (12, 60) selon une direction radiale;
- le dispositif élastique (48, 48′) de chaque dispositif de fixation (1, 1′) est intercalé entre la vis (49, 49′) de ce dispositif de fixation et l'un des supports (2, 2′).

4. Boîtier selon la revendication 3 caractérisé en ce que chaque première couronne (12, 60) est amovible et est fixée à une seconde couronne (13, 63) fixe et intégrée à la paroi;
et en ce que la première et la seconde couronnes (12, 60; 13, 63) ont des surfaces de contact qui sont uniquement radiales, les autres surfaces de ces deux couronnes n'étant pas en contact mais étant séparées par des jeux prédéterminés (J1 à J4).

5. Boîtier selon la revendication 4, caractérisé en ce que pour faciliter la mise en place- des réceptacles (3, 4) à l'intérieur de l'enveloppe (7), un secteur (55) de la seconde couronne (13) située à l'une des extrémités du boîtier, est absent;
en ce que la première couronne (12) fixée sur cette seconde couronne (13), comporte un secteur (57) en surépaisseur, qui occupe l'espace libre du secteur (55) qui est absent.

6. Boîtier selon la revendication 3, caractérisé en ce que, pour isoler électriquement les réceptacles (3, 4) par rapport à l'enveloppe (7), il comporte, en outre, à chaque extrémité du boîtier:
- des canons isolants (47, 47′) entourant respectivement les vis (49) pour isoler ces vis par rapport aux supports (2, 2′);
- des pièces isolantes (5) portées respectivement par les supports (2, 2′) pour isoler, d'une part, les supports (2, 2′) et les réceptacles (3, 4), et d'autre part les premières (12, 60) et les secondes couronnes (13, 63);
- une feuille mince (50) d'un matériau électriquement isolant, intercalé respectivement entre la paroi de l'enveloppe (7) et les couches (32, 34) de matériaux souples thermiquement conducteurs.

## Patentansprüche

1. Gehäuse für Seekabel-Elektronikschaltungen, das enthält:
- eine steife Hülle (7) zylindrischer Form mit kreisförmigem Querschnitt, die wärmeleitend und an ihren Enden dicht verschlossen ist,
- eine Vielzahl von steifen und wärmeleitenden Behältern (3, 4), die je eine Fläche aufweisen, deren Form komplementär zu der Form der Innenwand der Hülle ist, und die Elektronikschaltungen enthalten,
- Schichten (6, 32, 34) aus biegsamen wärmeleitenden Materialien, die zwischen den Flächen und der Wand angeordnet sind,
- Mittel, um jeden Behälter und die Schichten aus biegsamen Materialien gegen die Wand zu drücken,
dadurch gekennzeichnet, daß die Mittel zum Andrücken an jedem Ende des Gehäuses aufweisen:
- eine Vielzahl von Befestigungsvorrichtungen (1, 1′), die fest mit der Hülle (7) verbunden und regelmäßig um die Symmetrieachse der Hülle verteilt sind, wobei jede eine zentrifugale radiale Kraft ausübt und individuell einstellbar ist,
- Mittel (2, 45), um mindestens auf einen der Behälter (3, 4) die von jeder Befestigungsvorrichtung (1, 1′) ausgeübte zentrifugale, radiale Kraft zu übertragen.

2. Gehäuse nach Anspruch 1, dadurch gekennzeichnet, daß die Befestigungsmittel (1, 1′) eine elastische Vorrichtung (48, 48′) aufweisen.

3. Gehäuse nach Anspruch 1 und 2, dadurch gekennzeichnet, daß
- die Mittel zum Andrücken der biegsamen Schichten gegen die Wand an jedem Ende des Gehäuses einen ersten Ring (12, 60) aufweisen,
- die Mittel zur Übertragung einer Kraft auf die Behälter an jedem Ende des Gehäuses mehrere Träger (2, 2′) und Zwischenstücke (45) enthalten, wobei jedes Zwischenstück an zwei Trägern (2, 2′) befestigt ist, die sich an den beiden Enden des Gehäuses befinden und mindestens einen Behälter (3, 4) tragen,
- jede Befestigungsvorrichtung (1, 1′) eine Schraube (49, 49′) enthält, die in den ersten Ring (12, 60) entlang einer radialen Richtung eingeschraubt ist;
- die elastische Vorrichtung (48, 48′) jeder Befestigungsvorrichtung (1, 1′) zwischen die Schraube (49, 49′) dieser Befestigungsvorrichtung und einen der Träger (2, 2′) eingefügt ist.

4. Gehäuse nach Anspruch 3, dadurch gekennzeichnet, daß jeder erste Ring (12, 60) lösbar an einem zweiten Ring (13, 63) befestigt ist, der fest und in die Wand integriert ist, und daß der erste und der zweite Ring (12, 60; 13, 63) Kontaktflächen haben, die rein radial sind, während die anderen Oberflächen dieser beiden Ringe nicht in Kontakt sind, sondern durch vorbestimmte Abstände (J1 bis J4) voneinander getrennt sind.

5. Gehäuse nach Anspruch 4, dadurch gekennzeichnet, daß zur Vereinfachung der Anbringung der Behälter (3, 4) im Inneren der Hülle (7) ein Sektor (55) des zweiten Ringes (13), der sich an einem der Enden des Gehäuses befindet, fehlt, und daß der erste, auf diesem zweiten Ring (13) befestigte Ring (12) einen Sektor (57) in Überdicke aufweist, der den freien Raum des fehlenden Sektors (55) füllt.

6. Gehäuse nach Anspruch 3, dadurch gekennzeichnet, daß es zur elektrischen Isolierung der Behälter (3, 4) gegenüber der Hülle (7) außerdem an jedem Ende des Gehäuses aufweist:
- Isolierhülsen (47, 47′), die je eine der Schrauben (49) umgeben, um diese Schrauben gegenüber den Trägern (2, 2′) zu isolieren;
- Isolierteile (5), die von den Trägern (2, 2′) getragen werden, um die Träger (2, 2′) und die Behälter (3, 4) gegen die ersten (12, 60) und zweiten Ringe (13, 63) zu isolieren,
- eine dünne Folie (50) aus einem elektrisch isolierenden Material, die zwischen die Wand der Hülle (7) und die Schichten (32, 34) aus wärmeleitenden biegsamen Materialien eingeschoben ist.

## Claims

1. A housing for underwater electronic circuits, the housing comprising:
a thermally conductive rigid body (7) in the form of a circular section cylinder closed in watertight manner at its ends;
a plurality of thermally conductive rigid receptacles (3, 4) each having a face that is complementary in shape to the shape of the inside wall of the body, said receptacles containing electronic circuits;
layers (6, 32, 34) of thermally conductive flexible materials placed between said wall and said faces; and
thrust means for pressing each receptacle and the layers of flexible material against said wall;
the housing being characterized in that the thrust means comprise, at least end of the housing:
a plurality of fixing devices (1, 1′) fixed to the body (7) and regularly distributed around the axis of symmetry of the body, each fixing device exerting an individually adjustable radially-outward force; and
force-transmitting means (2, 45) for transmitting the radially-outward force exerted by each fixing device (1, 1′) to at least one of the receptacles (3, 4).

2. A housing according to claim 1, characterized in that the fixing devices (1, 1′) include resilient devices (48, 48′).

3. A housing according to claims 1 and 2, characterized in that:
the thrust means further include a first ring (12, 60) at each end of the housing;
the force-transmitting means include a plurality of supports (2, 2′) at each end of the housing together with a plurality of spacers (45); each spacer being fixed to two supports (2, 2′) situated at respective opposite ends of the housing and supporting at least one receptacle (3, 4);
each fixing device (1, 1′) including a screw (49, 49′) screwed radially into the first ring (12, 60); and
the resilient device (48, 48′) of each fixing device (1, 1′) is interposed between the screw (49, 49′) of said fixing device and one of the supports (2, 2′).

4. A housing according to claim 3, characterized in that each first ring (12, 60) is removable and is fixed to a fixed second ring (13, 63) which is integral with the wall; and
in that the first and second rings (12, 60; 13, 63) make contact with one another solely via radial surfaces, the other surfaces of the pairs of rings not making contact and being separated by predetermined amounts of clearance (J1 to J4).

5. A housing according to claim 4, characterized in that in order to facilitate installing receptacles (3, 4) inside the body (7), a sector (55) of the second ring (13) situated at one of the ends of the housing is missing; and
in that the first ring (12) fixed to said second ring (13) includes a sector (57) of increased thickness occupying the space left empty by the sector (55) which is missing.

6. A housing according to claim 3, characterized in that in order to insulate the receptacles electrically from the body (7) the housing further includes at each end thereof:
insulating sleeves (47, 47′) surrounding respective ones of the screws (49) to insulate them from the supports (2, 2′);
insulating pieces (5) carried by respective ones of the supports (2, 2′) and the receptacles (3, 4) from the first and second rings (12, 60; 13, 63);
a thin sheet (50); and
an electrically insulating material interposed between the wall of the body (7) and the layers (32, 34) of thermally conductive flexible materials.
